# EUROPÄISCHE PATENTSCHRIFT

(11) **EP 2 756 234 B1**
(45) Veröffentlichungstag und Bekanntmachung des Hinweises auf die Patenterteilung: **20.12.2017**
(21) Anmeldenummer: 12773242.8
(22) Anmeldetag: 14.09.2012
(51) Int. Cl.: F24J 2/04, F24J 2/46, F24J 2/52, H01L 31/05, H01L 31/048, H01L 31/049

(54) **PLATTENFÖRMIGES MODUL SOWIE VERFAHREN ZUM HERSTELLEN EINES RAHMENS FÜR EIN SOLCHES**
PLATE-SHAPED MODULE AND METHOD FOR PRODUCING A FRAME FOR SUCH A MODULE
MODULE EN FORME DE PLAQUE ET PROCÉDÉ DE FABRICATION D'UN CADRE POUR UN TEL MODULE

(30) Priorität: 14.09.2011 DE 102011053583
(43) Veröffentlichungstag der Anmeldung: 23.07.2014
(73) Patentinhaber: Reis Group Holding GmbH & Co. KG, 63785 Obernburg (DE)
(72) Erfinder: MERZ, Paul, 63834 Sulzbach (DE)
(74) Vertreter: Stoffregen, Hans-Herbert
(86) Internationale Anmeldenummer: PCT/EP2012/068084
(87) Internationale Veröffentlichungsnummer: WO 2013/037950

(56) Entgegenhaltungen:
- EP-A2- 0 325 369
- JP-A- 10 266 499
- US-A- 4 336 413

## Beschreibung

Die Erfindung bezieht sich auf ein plattenförmiges Modul, umfassend zumindest zwei plattenförmige Elemente mit umfangsseitig umlaufender Randversiegelung sowie das Modul umgebendem Rahmen, wobei der Rahmen ein Befestigungsmittel zum Befestigen des Moduls an einer Unterkonstruktion, wie Halterung, Fassade, aufweist. Auch nimmt die Erfindung Bezug auf ein Verfahren zum Herstellen eines Rahmens für ein plattenförmiges Modul umfassend zwei plattenförmige Elemente mit umlaufendem Rand, insbesondere ein Modul umfassend zwischen zwei plattenförmigen Elementen angeordnete Halbleiterbauelemente, wobei das Modul randseitig mit einer einen Rahmen bildenden Randversiegelung umgeben wird, und wobei der Rahmen an den Rand der plattenförmigen Elemente robotergeführt anextrudiert wird,

Aus der DE-U-20 2006 008 614 ist eine Trägermontagegruppe bekannt, die einen Kunststoffgrundkörper mit anextrudierten Montageelementen umfasst.

Eine von einem Roboter geführte Extrusionsdüse wird nach der DE-A-41 23 588 benutzt, um eine ein- oder mehrschichtige Glasscheibe mit einem aus einem thermoplastischen Elastomer bestehenden Rahmen zu versiegeln. Eine entsprechende Technik ist auch der DE-A-43 26 650 zu entnehmen.

Ein Solarmodul mit einer Randversiegelung ist aus der DE-C-199 50 893 bekannt. Die Randversiegelung umfasst einen Abstandshalter sowie einen Kleberstrang, die in einem Arbeitsgang durch Koextrusion ausgebildet werden.

Um aneinandergereihte Solarzellenmodule zu befestigen, sind nach der US-A-4,611,090 Träger vorgesehen, die mit Schrauben mit einem aus Kunststoff bestehenden Halterahmen der Module verbunden werden.

Gegenstand der DE-A-103 17 020 ist ein Modul. Eine elektrische Verbindung zwischen einzelnen Modulen erfolgt über Kupplungseinheiten, die durch Spritzgussmodulrahmen gebildet werden, die durch Rastverbindungen verbunden werden.

Die DE-A-41 40 682 hat ein Solarmodul mit angeformten Rahmen zum Gegenstand. Die einzelnen Rahmen der Module weisen versetzt zueinander verlaufende Verbindungsflansche auf, um die Module untereinander zu verbinden.

Der DE-A-10 2005 038 735 ist ein Solarzellenverbund zu entnehmen, von dem Befestigungselemente ausgehen.

Gegenstand der US-A-5,480,484 ist ein Solarzellenmodul, das einen aus Stahl bestehenden Halterahmen aufweist, der abgewinkelte Abschnitte aufweist, um eine Befestigung zu ermöglichen.

Die US-A-2002/0078991 offenbart eine Trägerstruktur für Solarzellenmodule, die aus Abschnitten von Vierkantprofilen besteht, die gegenüber den Solarzellen durch besondere Dichtmittel abgedichtet sind.

Aus der JP-A-06009501 ist ein Solarzellenmodul bekannt, das z.B. auf einem Fahrzeug oder auf einer Abdeckung angeordnet ist. Die Solarzellen werden von in ihren Randbereichen abgewinkelten Schichten aufgenommen.

Eine Solaranlage aus zumindest einem Solarmodul mit einer federnden Lagerung einer Abdeckplatte wird in der EP-A- 2 221 556 beschrieben.

Die DE-U-20 2010 000 293 bezieht sich auf eine Solardachanordnung.

In der US-A-2010/0193029 werden Befestigungen für Solarzellenmodule beschrieben, deren Randbereiche sich in Rahmenschenkeln erstrecken.

Durch Spritzgießen wird ein mehrteiliger Rahmen für ein Solarzellenmodul nach der WO-A-2010/019742 hergestellt.

Die EP-A-0 325 369 bezieht sich auf ein photovoltaisches Modul, das frontseitig versiegelt ist. Hierzu wird das Modul in eine Form eingelegt, um durch Spritzgießen einen das Modul umgebenden Rahmen herzustellen. In dem Rahmen werden Aussparungen ausgebildet, in denen elektrische Verschaltungselemente eingesetzt werden. EP-A-0 325 369 offenbart den Oberbegriff der Ansprüche 1 und 8. Ein Solar Panel nach der US-A-4 336 413 weist einen Rahmen aus einer Aluminiumlegierung auf, der durch Extrusion hergestellt ist. Zwischen dem Rahmen und dem Solar Panel wird eine gesonderte Abdichtung eingebracht.

Eine von einem Rahmen umgebene Solarzelle ist aus der JP-A-10266499 bekannt.

Nach dem Stand der Technik müssen Module über Befestigungsmittel wie Schrauben mit Halterungen verbunden werden, damit die Module z.B. aufgeständert oder als Fassadenverkleidung verwendet werden können. Dies ist montagemäßig aufwendig. Von Nachteil ist des Weiteren, dass dann, wenn ein Modul ausgetauscht werden soll, es häufig Schwierigkeiten bereitet, das Modul von der Halterung zu lösen, da die Verbindungselemente korrodiert sind.

Der vorliegenden Erfindung liegt die Aufgabe zugrunde, ein plattenförmiges Modul der eingangs genannten Art bzw. ein Verfahren zur Herstellung eines Rahmens für ein solches derart weiterzubilden, dass mit konstruktiv einfachen Maßnahmen eine Befestigung möglich ist. Gleichzeitig soll eine hinreichende Dichtung des Moduls gegeben sein. Ferner soll das Modul eindeutig fixiert von dem Rahmen umgeben werden können.

Erfindungsgemäß wird zur Lösung der Aufgabe verfahrensmäßig im Wesentlichen vorgeschlagen, dass die den Rahmen bildende Randversiegelung an die plattenförmigen Elemente anextrudiert ist, dass sich die plattenförmigen Elemente mit ihren Randabschnitten in dem Rahmen erstrecken, und dass das Befestigungsmittel eine Aufnahme ist und integral mit dem Rahmen ausgebildet ist, wobei die Aufnahme eine schlitzförmige oder teilweise formumschließende Öffnung aufweist, die in einer Ebene verläuft, die parallel oder in etwa parallel zur von dem Modul aufgespannten Ebene verläuft.

Insbesondere weist der Rahmen bzw. dessen Schenkel im Schnitt eine rechteckförmige Geometrie mit öffnungsseitiger Grundfläche, in diese übergehende Seitenflächen sowie gegenüberliegend zur Grundfläche verlaufender Kopffläche auf, wobei jeder Schenkel einen innen verlaufenden Kanal mit in die Öffnung übergehender Basis aufweist, deren Erstreckung größer ist als die der Öffnung.

Dabei ist für den Kanal insbesondere eine Geometrie derart vorgesehen, dass dieser im Schnitt quer zur Längserstreckung des jeweiligen Schenkels eine Kreis- oder Ovalabschnittsgeometrie mit der öffnungsseitig verlaufenden ebenen Basis aufweist.

Erfindungsgemäß wird ein Modul von einem anextrudierten eine Randversiegelung bildenden Rahmen umgeben, der nicht nur die Funktion der Abdichtung des Bereichs zwischen den Plattenelementen, sondern auch die Funktion einer Befestigung des Moduls selbst ausübt. Abdichtung und Befestigung sind Abschnitte eines einteilig extrudierten Rahmens. Hierzu weisen die Schenkel des Rahmens entsprechende als innere Kanäle ausgebildete Aufnahmen auf, wobei sich eine maulartige Geometrie ergibt, um ein von z.B. einer Auflage oder Fassadenfläche ausgehendes Halteelement wie wulstartigen Vorsprung aufzunehmen. Somit ist mit konstruktiv einfachen Maßnahmen eine Befestigung des Moduls möglich, ohne dass es gesonderter Bauelemente wie Schrauben bedarf. Durch das Anextrudieren des Rahmens kann ein vollautomatischer Verfahrensablauf erfolgen, der sicherstellt, dass die Versiegelung des Moduls im notwendigen Umfang gewährleistet ist.

Das Anextrudieren des Rahmens und damit der Randversiegelung ist unabhängig von dem Verlauf der Ränder der plattenförmigen Elemente. So können diese senkrecht zu der von diesen aufgespannten Ebene verlaufende Randabschnitte aufweisen, die die Kopffläche der Schenkel des Rahmens durchsetzen. Es besteht jedoch auch die Möglichkeit, dass die in der von den plattenförmigen Elementen aufgespannten Ebenen verlaufenden Randabschnitte die Rahmenschenkel in ihren modulzugewandten Seitenflächen durchsetzen.

Um erfindungsgemäß mit einem anextrudierten Rahmen versehene Module abgedichtet zumindest im Längs- und Querrandbereich aneinanderreihen zu können, sieht die Erfindung vor, dass von dem Rahmen eine Dichtlippe ausgeht, die sowohl über der modulabgewandten Seitenfläche als auch der Kopffläche der Schenkel vorsteht.

Ein Verfahren zum Herstellen eines Rahmens für ein plattenförmiges Modul der eingangs genannten Art zeichnet sich im Wesentlichen dadurch aus, dass der Rahmen integral mit einem Befestigungsmittel zum Befestigen des Moduls an einer Unterkonstruktion extrudiert wird, wobei das Befestigungsmittel als eine Aufnahme in Form eines in Längsrichtung des Rahmens bzw. dessen Schenkels verlaufenden maulartigen oder formumschließenden Kanals ausgebildet wird.

Robotergeführt anextrudiert bedeutet, dass entweder das Modul entlang einer vorzugsweise direkt an einem Extruder positionierten Düse vorbeigeführt oder die Düse entlang des Moduls mittels eines Roboters geführt wird, um das Anextrudieren durchzuführen.

Insbesondere wird die Aufnahme insbesondere in Längsrichtung der Rahmenschenkel als maulartig verlaufender Kanal ausgebildet, so dass sich infolgedessen ein Hohlraum mit Längsschlitz ergibt, dessen Seitenschenkel einander zugewandt sind. Infolgedessen kann mit einfachen Maßnahmen eine aufgeständerte zylinderartig ausgebildete Halterung in den maulartigen Kanal eingedrückt werden, wobei der zylinderartige Abschnitt formschlüssig von den Begrenzungswandungen des Kanals umschlossen werden kann. Hierdurch ist ein sicheres Fixieren des Rahmens und damit des Moduls sichergestellt, ohne dass zusätzliche Befestigungsmittel erforderlich sind.

Insbesondere ist vorgesehen, dass die Schenkel des Rahmens in quaderförmiger Geometrie mit einer Grundfläche, von dieser ausgehende Seitenflächen und der Grundfläche gegenüberliegender Kopffläche extrudiert wird, wobei die Grundfläche von einem in die Aufnahme übergehenden Längsschlitz durchsetzt wird und der Rand des Moduls eine der Seitenflächen oder die Kopffläche durchsetzt, je nachdem, wie die Randabschnitte des Moduls in Bezug auf die von diesem aufgespannte Ebene verlaufen, also in der Ebene oder abgewinkelt zu dieser.

Des Weiteren sieht die Erfindung vor, dass der Rahmen bzw. dessen Schenkel mit einer Dichtlippe ausgebildet wird, die sowohl über der Kopffläche als auch der plattenfernliegenden Seitenfläche des Rahmens vorsteht.

Als Materialien für den Rahmen werden insbesondere thermoplastische Elastomere vorzugsweise auf Polyurethanbasis oder Thermoplaste verwendet.

Vorzugsweise sind thermoplastische Polyolefin-Elastomere aus isotaktischem Polypropylen und Ethylen-Propylen-Dien-Kautschuk zu nennen, ohne dass hierdurch die erfindungsgemäße Lehre eingeschränkt werden soll.

Die Erfindung nimmt auch Bezug auf eine Handhabungseinrichtung zur Durchführung des Verfahrens zum Herstellen eines Rahmens für ein plattenförmiges Solarzellenmodul umfassend zwei plattenförmige Elemente mit umlaufendem Rand, wobei das Modul randseitig mit einer Randversiegelung versehen und von einem Rahmen umgeben wird, mit einer relativ entlang des umlaufenden Rands des Moduls bewegbaren Extrusionsdüse.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung eines bevorzugten Ausführungsbeispiels.

Es zeigen:
- Fig. 1: eine Modulanordnung,
- Fig. 2: einen Schnitt entlang der Linie B-B in Fig. 1,
- Fig. 3: einen Ausschnitt einer weiteren Ausführungsform eines mit einem Modul verbundenen Rahmens und
- Fig. 4 und 5: Abschnitte von weiteren Ausführungsformen von Rahmen im Querschnitt.

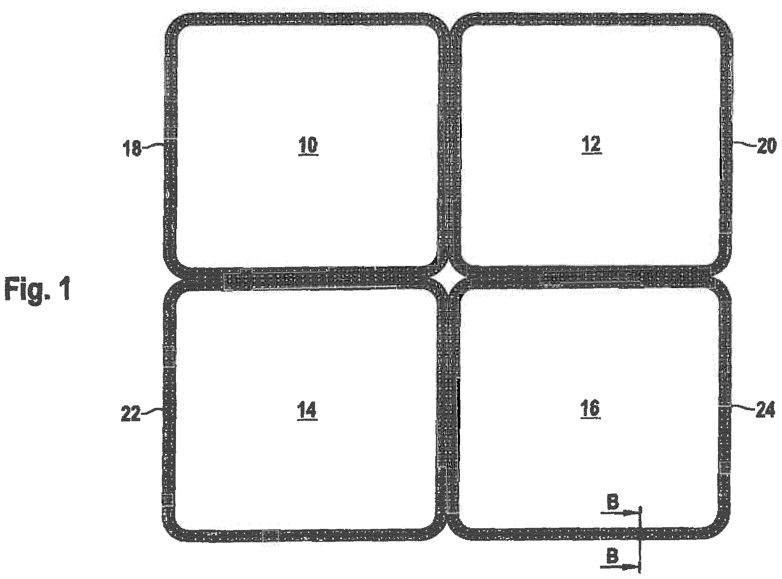

In der Fig. 1 sind rein prinzipiell vier Module 10, 12, 14, 16 dargestellt, bei denen es sich um Solarzellenmodule handeln kann, ohne dass hierdurch die erfindungsgemäße Lehre eingeschränkt werden soll.

Ein typisches Solarmodul umfasst eine Glasscheibe auf der der Strahlung zugewandten Seite, eine transparente Kunststoffschicht wie EVA, in der die Solarzellen eingebettet sind, bei denen es sich z.B. um mono- oder polykristalline Solarzellen handelt, die miteinander verschaltet sind, eine Rückseitenkaschierung mit einer witterungsfesten Kunststoffverbundfolie wie Tedla und Polyester sowie Anschlussdosen und Terminals und Bypassdioden. Die so gebildeten Einheiten werden sodann von einer Randversiegelung umgeben, um das Eindringen von Feuchtigkeit zu verhindern. Anschließend werden die Module von einem Rahmen aufgenommen.

Erfindungsgemäß ist vorgesehen, dass Randversieglung und Rahmen eine Einheit bilden und robotergeführt randseitig an das jeweilige Modul 10, 12, 14, 16 anextrudiert sind. Die Module 10, 12, 14, 16 werden folglich jeweils von einem umlaufenden Rahmen 16, 18, 20, 22, 24 umgeben, der gleichzeitig die Randversiegelung sicherstellt. Erfindungsgemäß ist des Weiteren vorgesehen, dass der jeweilige Rahmen 18, 20, 22, 24 derart ausgebildet ist, dass dieser gleichzeitig als Befestigungsmittel zum Fixieren des jeweiligen Rahmens 18, 20, 22, 24 und damit des Moduls 10, 12, 14, 16 auf einer Unterkonstruktion wie Halterung ermöglicht, die z.B. von einer Auflage oder Fassade ausgehen kann.

Robotergeführt randseitig anextrudieren bedeutet, dass entweder eine - gegebenenfalls sich um ihre Achse drehende - Extrusionsdüse stationär angeordnet und das Modul mittels eines Roboters entlang der Düse oder die Düse von einem Roboter entlang des Moduls geführt wird.

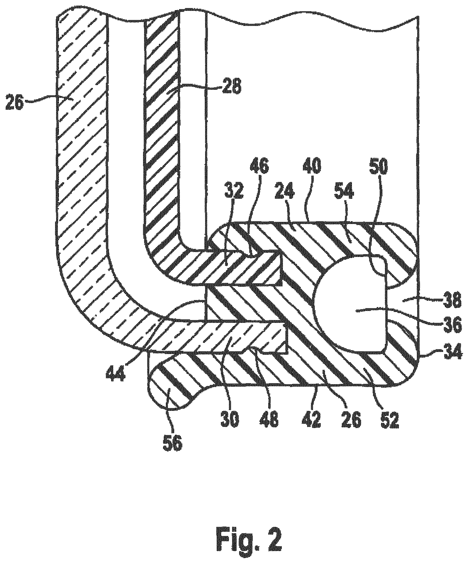

In der Fig. 2 ist ein Schnitt des Rahmens 24 dargestellt, der die Dreifachfunktion ausübt, also die Versieglung, die Bildung des Rahmens und das zur Verfügungstellen von Befestigungsmitteln.

In Fig. 2 sind mit dem Bezugszeichen 26 die äußere Glasscheibe des Moduls 16 und mit dem Bezugszeichen 28 die rückseitige Kunststoffverbundfolie gekennzeichnet, zwischen denen die Solarzellen und das Einbettungsmaterial verlaufen. Glasscheibe 26 und Kunststoffverbundfolie 28 sind plattenförmige Elemente. Im Ausführungsbeispiel sind die Glasscheibe 26 und die Kunststoffverbundfolie 28 randseitig abgewinkelt. Die entsprechenden Randabschnitte sind mit den Bezugszeichen 30, 32 gekennzeichnet. Somit laufen die Randabschnitte 30, 32 in etwa im rechten Winkel zu den von der Glasscheibe 26 und der Kunststoffverbundfolie 28 aufgespannten Ebenen, die ihrerseits parallel zueinander verlaufen. Um die Randbereiche 30, 32 wird erfindungsgemäß robotergeführt der Rahmen 24 anextrudiert.

Der Rahmen 24, der jedes Modul wie das Modul 16 umlaufend umgibt, d.h. dessen Schenkel, weist im Schnitt eine Rechteckgeometrie auf, wie die Fig. 2 verdeutlicht. Auf der der Glasscheibe 26 und der Kunststoffverbundfolie 28 abgewandten Fläche 34, die als Grundfläche bezeichnet wird, verläuft eine in einen inneren Kanal 36 übergehende schlitzförmige Öffnung 38. An die Grundfläche 34 grenzen eine modulseitig verlaufende erste Seitenfläche 40 und eine modulabgewandte zweite Seitenfläche 42 an. Gegenüberliegend zur Grundfläche 34 verläuft eine Kopffläche 44. Die Öffnung 38 mit dem inneren Kanal 36 kann somit als teilweise formumschließende Öffnung bezeichnet werden.

Das Anextrudieren des Rahmens 24 erfolgt derart, dass die abgewinkelten Randabschnitte 32, 34 die Kopffläche 44 des Rahmens 24 bzw. dessen Schenkel durchsetzen, wie die Fig. 2 verdeutlicht. Um ein sicheres Fixieren des Extrusionsmaterials und damit des Rahmens 24 sicherzustellen, weisen die Randabschnitte 30, 32 bevorzugterweise parallel zu den Stirnflächen verlaufende Sicken 46, 48 auf. Dabei können selbstverständlich mehr als eine Sicke in der Glasscheibe 26 bzw. in der Kunststoffverbundfolie 28 vorgesehen sein. Anstelle eines oder mehrerer Sicken 46, 48 können von den Abschnitten 30, 32 auch Vorsprünge abragen.

Sind die Randabschnitte nicht abgewinkelt, so ist der Rahmen derart anextrudiert, dass die Seitenfläche 40 von den in der von der Glasscheibe 26 bzw. der Kunststoffverbundfolie 28 aufgespannten Ebene verlaufenden Randabschnitten durchsetzt wird. Unabhängig hiervon verläuft die Öffnung 38, d. h. eine von dieser aufgespannten Ebene parallel zu den plattenförmigen Elementen 26, 28.

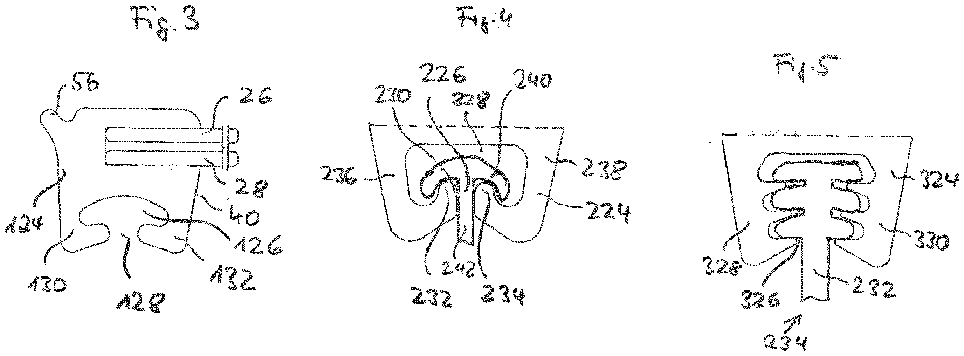

Eine entsprechende Ausführungsform ist der Fig. 3 zu entnehmen. Dabei sind entsprechend der Fig. 2 für gleiche Elemente gleiche Bezugszeichen verwendet worden. In Fig. 3 weisen die plattenförmigen Elemente in Form z. B. der Glasscheibe 26 und der Kunststoffverbundfolie 28 keine abgewinkelten Randabschnitte auf, wie diese der Fig. 2 zu entnehmen sind. Entlang der Längsränder der Elemente 26, 28 wird entsprechend der erfindungsgemäßen Lehre ein Rahmen 124 mittels eines Roboter-geführten Extrusionswerkzeugs anextrudiert, der die erforderliche Randversiegelung sicherstellt. Gleichzeitig dient der Rahmen 124 als Befestigung der Platten an einer Unterkonstruktion wie Halterung, die z. B. an einer Fassade befestigt sein kann. Die Halterung kann aber auch selbst Abschnitt einer Fassade sein. Um die Unterkonstruktion mit dem Rahmen 124 zu verbinden, weist der Rahmen 124 entsprechend der Fig. 3 eine in einen Hohlraum 126 übergehende Öffnung 128 auf, die in einer Ebene verläuft, die sich parallel zu den Elementen 26, 28 erstreckt. Dabei weist die Öffnung 128 eine lichte Breite auf, die geringer als maximale Breitenerstreckung des Hohlraums 126 entlang der Elemente 26, 28 ist. Es ergibt sich eine Art maulartige Aufnahme, in die ein Abschnitt einer geometrisch angepassten Halterung einbringbar ist, die somit teilweise formumschließend von dem Rahmen 124 aufgenommen wird. Zum Einbringen des Abschnitts der Aufnahme werden die die Öffnung 128 und den Hohlraum 126 begrenzenden Seitenschenkel 130, 132 des Rahmens 124 auseinandergebogen. Halterung und Rahmen 124 greifen somit quasi in einer Art Schnappverbindung ineinander ein.

Entsprechend der Fig. 4 und 5 können die Aufnahmen oder gleichwirkenden Elemente, die integral in den die Randversiegelung bildenden Rahmen durch Extrudieren ausgebildet werden, auch andere Geometrien aufweisen. So ist der Fig. 4 ein Abschnitt eines Rahmens 224 im Schnitt zu entnehmen, der einen einen Abschnitt einer Halterung 226 aufnehmenden Hohlraum 228 aufweist. Der Hohlraum 228 geht von einer Öffnung 230 aus, die durch zwei nach innen abgewinkelte Schenkel 232, 234 des Rahmens 224 begrenzt ist. Im Schnitt weisen die den Hohlraum 228 begrenzenden Schenkel 236, 238 des Rahmens 224 eine einander zugewandte Hakengeometrie auf. Die nach innen gerichteten hakenförmigen Schenkelabschnitte 232, 234 bilden somit ein Auflager für die Halterung 226, d. h., dessen sich im Inneren des Hohlraums 228 erstreckenden Abschnitts 240, der im Schnitt eine Bogengeometrie mit mittig ausgehendem Steg 242 aufweist. Durch die Anpassung des Abschnitts 240 und dessen Erstreckung in dem Hohlraum 228 zu den hakenförmig abgewinkelten Schenkeln 232, 234 wird sichergestellt, dass sich bei einer Zugwirkung auf den Rahmen 224 die Enden der hakenförmigen Schenkel 232, 234 in dem Zwischenraum zwischen dem bogenförmigen Abschnitt 240 der Halterung 226 und dem die Öffnung 230 durchsetzenden Steg 242 erstrecken und hierdurch fixiert werden, so dass ein Lösen der Halterung 226 von dem Rahmen 224 und damit dem Modul nicht erfolgt, das von dem Rahmen 224 umgeben ist.

Mit anderen Worten weist der die Halterung 226 in dem mit dem Rahmen 224 zusammenwirkenden Bereich im Schnitt eine pilzartige Geometrie auf.

In Fig. 5 ist ein Abschnitt eines Rahmens 324 im Schnitt dargestellt, dessen Öffnung 326 von Schenkeln 328, 330 begrenzt sind, die eine sägezahnförmige Geometrie aufweisen. Eine geometrisch angepasste Geometrie weist ein in den Rahmen 324 einsteckbaren Abschnitt 332 einer Halterung 334 auf, die folglich der sägezahnförmigen Aussparung in den Schenkeln 328, 330 angepasste Vorsprünge, eine Art Tannengeometrie aufweist, damit ein Verrasten zwischen diesen erfolgen kann. Auch durch die diesbezügliche Geometrie ist sichergestellt, dass bei einer Zugeinwirkung auf den Rahmen 324 ein Lösen von der Halterung 334 durch das Zusammenwirken der von dem Abschnitt 232 der Halterung 334 ausgehenden Vorsprünge mit den sägezahnförmig ausgebildeten Innenseiten der Schenkel 328, 330 der Halterung 324 nicht möglich ist.

Der innere Kanal 36 weist im Schnitt eine Kreisabschnittsgeometrie mit ebener Basis 50 auf, die von der Öffnung 38 durchsetzt wird. Somit wird der innere Kanal 36 von Schenkeln 52, 54 begrenzt, die aufgrund des Extrusionsmaterials in einem Umfang elastisch sind, dass die Öffnung 38 von einem Befestigungsmittel durchsetzt werden kann, dessen lichte Breite größer als lichte Breite der Öffnung 38 ist.

Es erfolgt quasi ein Einrasten in den inneren Kanal 36 eines entsprechenden Befestigungselements, dessen Außengeometrie der Innengeometrie des Kanals 36 entsprechen sollte. Mit anderen Worten, weist entsprechend der der Fig. 2 zu entnehmenden Geometrien das Befestigungsmittel einen Zylinderabschnitt auf, der in den Kanal 36 eingreift. Die "Rastrichtung" verläuft somit senkrecht zu der von der Öffnung 38 aufgespannten Ebene.

Somit ist mit einfachen Maßnahmen ein Fixieren des Rahmens 24 und somit des Moduls 16 auf einer Halterung möglich.

Damit aneinandergereihte Module wie die Module 10, 12, 14, 16 außerhalb deren Ecken abgedichtet aneinandergrenzen, geht des Weiteren vom Schnittpunkt der Kopffläche 44 und der modulabgewandten Seitenfläche 42 eine Dichtlippe 56 aus, die die Kopffläche 44 und die Seitenfläche 42 überragt, wie die zeichnerische Darstellung verdeutlicht.

Die den Kanal 36 begrenzenden, eine Rastverbindung ermöglichenden Schenkel weisen bevorzugterweise eine Dicke zwischen 2 mm und 8 mm und eine Länge zwischen 4 mm und 8 mm auf.

Die Erfindung wird nicht verlassen, wenn die Aufnahme, also die kanalförmige Aussparung 36 eine andere Geometrie aufweist.

## Patentansprüche

1. Plattenförmiges Modul (10, 12, 14, 16), umfassend zumindest zwei plattenförmige Elemente (26, 28) mit umfangsseitig umlaufender Randversiegelung sowie das Modul umgebendem Rahmen (18, 20, 22, 24, 124, 224, 324), wobei der Rahmen ein Befestigungsmittel zum Befestigen des Moduls an einer Unterkonstruktion, wie Halterung, Fassade, aufweist,
**dadurch gekennzeichnet,**
**dass** die den Rahmen (18, 20, 22, 24, 124, 224, 324) bildende Randversiegelung an die plattenförmigen Elemente (26, 28) anextrudiert ist, dass sich die plattenförmigen Elemente mit ihren Randabschnitten in dem Rahmen erstrecken, und dass das Befestigungsmittel eine Aufnahme ist und integral mit dem Rahmen ausgebildet ist, wobei die Aufnahme eine schlitzförmige oder teilweise formumschließende Öffnung (38) aufweist, die in einer Ebene verläuft, die parallel oder in etwa parallel zur von dem Modul (10, 12, 14, 16) aufgespannten Ebene verläuft.

2. Plattenförmiges Modul nach Anspruch 1,
**dadurch gekennzeichnet,**
**dass** der Rahmen (18, 20, 22, 24, 124, 224, 324) bzw. dessen Schenkel eine Rechteckgeometrie mit von der Öffnung (38) durchsetzter Grundfläche (34), in diese übergehenden Seitenflächen (40, 42) sowie gegenüberliegend zu der Grundfläche verlaufender Kopffläche (44) aufweist, dass jeder Schenkel einen inneren Kanal (36) mit in die Öffnung (38) übergehender Basis (50) aufweist, deren Erstreckung größer als die der Öffnung ist.

3. Plattenförmiges Modul nach Anspruch 2,
**dadurch gekennzeichnet,**
**dass** der Kanal (36) im Schnitt quer zur Längserstreckung des Rahmens bzw. dessen Schenkel eine Kreis- oder Ovalabschnittsgeometrie mit öffnungsseitig verlaufender ebener Basis (50) aufweist.

4. Plattenförmiges Modul nach Anspruch 2,
**dadurch gekennzeichnet,**
**dass** die plattenförmigen Elemente (26, 28) senkrecht zu den von diesen aufgespannten Ebenen verlaufende Randabschnitte (30, 32) aufweisen, die die Kopffläche (44) des Rahmens (18, 20, 22, 24) durchsetzen.

5. Plattenförmiges Modul nach zumindest Anspruch 1,
**dadurch gekennzeichnet,**
**dass** die in den von den plattenförmigen Elementen (26, 28) aufgespannten Ebenen verlaufenden Randabschnitte der plattenförmigen Elemente eine der Seitenflächen (40) des Rahmens bzw. dessen Schenkel durchsetzen.

6. Plattenförmiges Modul nach zumindest Anspruch 1,
**dadurch gekennzeichnet,**
**dass** von den sich in dem Rahmen (18, 20, 22, 24, 124, 224, 324) erstreckenden Abschnitten (30, 32) der plattenförmigen Elemente (26, 28) Vorsprünge ausgehen oder in den Abschnitten Sicken (46, 48) ausgebildet sind.

7. Plattenförmiges Modul nach zumindest Anspruch 1,
**dadurch gekennzeichnet,**
**dass** von dem Rahmen (18, 20, 22, 24, 124, 224, 324) bzw. dessen Schenkel eine Dichtlippe (56) abragt, die sowohl über der modulabgewandten Seitenfläche (42) als auch der Kopffläche (44) des Rahmens (18, 20, 22, 24, 124, 224, 324) bzw. dessen Schenkeln vorsteht.

8. Verfahren zum Herstellen eines Rahmens für ein plattenförmiges Modul (10, 12, 14, 16) nach zumindest Anspruch 1 umfassend zwei plattenförmige Elemente (26, 28) mit umlaufendem Rand, insbesondere ein Modul umfassend zwischen zwei plattenförmigen Elementen angeordnete Halbleiterbauelemente, wobei das Modul randseitig mit einer einen Rahmen (18, 20, 22, 24, 124, 224, 324) bildenden Randversiegelung umgeben wird, und wobei der Rahmen (18, 20, 22, 24) an den Rand (30, 32) der plattenförmigen Elemente (26, 28) robotergeführt anextrudiert wird,
**dadurch gekennzeichnet,**
**dass** der Rahmen (18, 20, 22, 24, 124, 224, 324) integral mit einem Befestigungsmittel (36, 38) zum Befestigen des Moduls an einer Unterkonstruktion extrudiert wird, wobei das Befestigungsmittel als eine Aufnahme in Form eines in Längsrichtung des Rahmens (18, 20, 22, 24) bzw. dessen Schenkel verlaufender maulartiger oder formumschließender Kanal (36) ausgebildet wird.

9. Verfahren nach Anspruch 8,
**dadurch gekennzeichnet,**
**dass** der Rahmen bzw. dessen Schenkel (18, 20, 22, 24, 124, 224, 324) in quaderförmiger Geometrie mit einer Grundfläche (34), von dieser ausgehenden Seitenfläche (40, 42) und der Grundfläche gegenüberliegender Kopffläche (44) extrudiert wird, wobei die Grundfläche von einem in die Aufnahme übergehenden eine Öffnung (38) bildenden Längsschlitz durchsetzt wird.

10. Verfahren nach Anspruch 8 oder 9,
**dadurch gekennzeichnet,**
**dass** der Rahmen (18, 20, 22, 24, 124, 224, 324) an die plattenförmigen Elemente (26, 28) derart extrudiert wird, dass deren Ränder (30, 32) eine der Seitenflächen (40, 42) oder die Kopffläche (44) des Rahmens bzw. dessen Schenkel durchsetzt.

11. Verfahren nach einem der Ansprüche 8 bis 10,
**dadurch gekennzeichnet,**
**dass** der Rahmen (18, 20, 22, 24) bzw. dessen Schenkel mit einer Dichtlippe (56) ausgebildet wird, die sowohl über der Kopffläche (44) als auch der modulfernliegenden Seitenfläche (42) des Rahmens bzw. dessen Schenkel vorsteht.

12. Verfahren nach einem der Ansprüche 8 bis 11,
**dadurch gekennzeichnet,**
**dass** das Anextrudieren bei stationär angeordneter, gegebenenfalls um ihre Achse sich drehender Extrusionsdüse durchgeführt wird, an der das Modul robotergeführt entlang bewegt wird.

13. Handhabungseinrichtung zur Durchführung des Verfahrens nach zumindest Anspruch 8 mit einer entlang des umlaufenden Rand des Moduls bewegbaren Extrusionsdüse.

## Claims

1. Plate-like module (10, 12, 14, 16), comprising at least two plate-like elements (26, 28) with all-round edge seal on the circumference side and with frame (18, 20, 22, 24, 124, 224, 324) surrounding said module, said frame having a fastening means for fastening the module to a substructure such as a holder or facade,
wherein
the edge seal forming the frame (18, 20, 22, 24, 124, 224, 324) is extruded onto the plate-like elements (26, 28), said plate-like elements extend with their edge sections in the frame, and the fastening means is a receptacle and is designed integral with the frame, said receptacle having a slot-like or partially form-enclosing opening (38) extending in a plane that is parallel or approximately parallel to the plane created by the module (10, 12, 14, 16).

2. Plate-like module according to claim 1,
**wherein**
the frame (18, 20, 22, 24, 124, 224, 324) or its side has a rectangular geometry with a base surface (34) passed through by the opening (38), side surfaces (40, 42) merging into said base surface, and a top surface (44) opposite to said, and each side has an inner duct (36) with base (50) merging into said opening (38) and whose extent is larger than the opening.

3. Plate-like module according to claim 2,
**wherein**
the duct (36) has in a section transverse to the longitudinal extent of the frame or its side a geometry of a circular or oval segment with a flat base (50) on the opening side.

4. Plate-like module according to claim 2,
**wherein**
the plate-like elements (26, 28) have edge sections (30, 32) vertical to the planes created by said elements and passing through the top surface (44) of the frame (18, 20, 22, 24).

5. Plate-like module according to at least claim 1,
**wherein**
the edge sections of the plate-like elements extending in the planes created by said plate-like elements (26, 28) pass through one of the side surfaces (40) of the frame or its side.

6. Plate-like module according to at least claim 1,
**wherein**
projections emanate from the sections (30, 32) of the plate-like elements (26, 28) extending inside the frame (18, 20, 22, 24, 124, 224, 324) or beads (46, 48) are provided in said sections.

7. Plate-like module according to at least claim 1,
**wherein**
a sealing lip (56) projects from the frame (18, 20, 22, 24, 124, 224, 324) or its side, and protrudes both beyond the side surface (42) facing away from the module and beyond the top surface (44) of the frame (18, 20, 22, 24, 124, 224, 324) or its sides.

8. Method for manufacturing a frame for a plate-like module (10, 12, 14, 16) according to at least claim 1, comprising two plate-like elements (26, 28) with all-round edge, in particular a module comprising semiconductor components arranged between two plate-like elements, said module being surrounded at the rim with an edge seal forming a frame (18, 20, 22, 24, 124, 224, 324), and said frame (18, 20, 22, 24) being extruded onto the edge (30, 32) of said plate-like elements (26, 28) under robot control,
**wherein**
the frame (18, 20, 22, 24, 124, 224, 324) is integrally extruded with a fastening means (36, 38) for fastening the module to a substructure, said fastening means being designed as a receptacle in the form of a jaw-like or form-enclosing duct (36) extending in the longitudinal direction of the frame (18, 20, 22, 24) or its side.

9. Method according to claim 8,
**wherein**
the frame or its side (18, 20, 22, 24, 124, 224, 324) is extruded with a block-like geometry with a base surface (34), side surfaces (40, 42) emanating therefrom, and top surface (44) opposite said base surface, said base surface being passed through by a longitudinal slot merging into the receptacle and forming an opening (38).

10. Method according to claim 8 or 9,
**wherein**
the frame (18, 20, 22, 24, 124, 224, 324) is extruded onto the plate-like elements (26, 28) such that its edges (30, 32) pass through one of the side surfaces (40,42) or the top surface (44) of said frame or its side respectively.

11. Method according to one of claims 8 to 10,
**wherein**
the frame (18, 20, 22, 24) or its side is designed with a sealing lip (56) protruding both beyond the top surface (44) and beyond the side surface (42) of the frame or its side remote from the module.

12. Method according to one of claims 8 to 11,
**wherein**
the extrusion is performed with an extrusion nozzle stationarily arranged or where necessary rotating about its axis, along which extrusion nozzle the module is moved under robot control.

13. Handling device for performing the method according to at least claim 8 with an extrusion nozzle movable along the all-round edge of the module.

## Revendications

1. Module en forme de plaque (10, 12, 14, 16) comprenant au moins deux éléments en forme de plaque (26, 28) avec scellement périphérique sur tout le pourtour côté circonférentiel ainsi qu'un cadre (18, 20, 22, 24, 124, 224, 324) entourant ledit module, sachant que ledit cadre présente un moyen de fixation servant à fixer le module sur une sous-construction telle que support ou façade,
**caractérisé en ce**
**que** le scellement périphérique formant le cadre (18, 20, 22, 24, 124, 224, 324) est extrudé sur les éléments en forme de plaque (26, 28), que les bords des éléments en forme de plaque s'étendent dans le cadre et que le moyen de fixation est un logement formé d'un seul tenant avec le cadre, sachant que ledit logement présente une ouverture (38) en forme de fente ou enserrant partiellement une autre forme et qu'il se situe dans un plan parallèle ou presque parallèle au plan sous-tendu par le module (10, 12, 14, 16).

2. Module en forme de plaque selon la revendication 1,
**caractérisé en ce**
**que** le cadre (18, 20, 22, 24, 124, 224, 324) ou son côté présente une géométrie rectangulaire avec une surface de base (34) traversée par l'ouverture (38), des surfaces latérales (40, 42) se fondant dans ladite surface de base et une surface supérieure (44) opposée à la surface de base, que chaque côté présente un canal interne (36) avec une base (50) se confondant avec l'ouverture (38) et ayant une dimension supérieure à celle de l'ouverture.

3. Module en forme de plaque selon la revendication 2,
**caractérisé en ce**
**que** le canal (36) qui est, en coupe, transversal au cadre ou à son côté, présente une géométrie en forme de segment circulaire ou ovale avec une base (50) plane du côté de l'ouverture.

4. Module en forme de plaque selon la revendication 2,
**caractérisé en ce**
**que** les éléments en forme de plaque (26, 28) présentent des parties marginales (30, 32) verticales aux plans sous-tendus par lesdits éléments, lesquelles parties marginales traversent la surface supérieure (44) du cadre (18, 20, 22, 24).

5. Module en forme de plaque selon au moins la revendication 1,
**caractérisé en ce**
**que** les parties marginales des éléments en forme de plaque (26, 28) s'étendant dans les plans sous-tendus par lesdits éléments en forme de plaque traversent une des surfaces latérales (40) du cadre ou son côté.

6. Module en forme de plaque selon au moins la revendication 1,
**caractérisé en ce**
**que** des saillies dépassent des parties (30, 32) appartenant aux éléments en forme de plaque (26, 28) et s'étendant dans le cadre (18, 20, 22, 24, 124, 224, 324) ou que des moulures (46, 48) sont réalisées dans lesdites parties.

7. Module en forme de plaque selon au moins la revendication 1,
**caractérisé en ce**
**qu'**une lèvre d'étanchéité (56) dépasse du cadre (18, 20, 22, 24, 124, 224, 324) ou de son côté, laquelle lèvre déborde aussi bien de la surface latérale (42) opposée au module que de la surface supérieure (44) du cadre (18, 20, 22, 24, 124, 224, 324) ou de ses côtés.

8. Procédé pour la fabrication d'un cadre pour un module en forme de plaque (10, 12, 14, 16) selon au moins la revendication 1, comprenant deux éléments en forme de plaque (26, 28) avec un bord sur tout le pourtour, notamment un module comprenant des composants à semi-conducteur disposés entre deux éléments en forme de plaque, sachant que le module est entouré du côté du bord d'un scellement périphérique formant un cadre (18, 20, 22, 24, 124, 224, 324) et sachant que le cadre (18, 20, 22, 24) est extrudé avec guidage par robot sur le bord (30, 32) des éléments en forme de plaque (26, 28),
**caractérisé en ce**
**que** le cadre (18, 20, 22, 24, 124, 224, 324) est extrudé d'un seul tenant en comprenant un moyen de fixation (36, 38) qui sert à fixer le module sur une sous-construction, sachant que ledit moyen de fixation est constitué d'un logement sous forme de canal (36) ressemblant à une mâchoire ou enserrant une autre forme, et s'étendant dans le sens longitudinal du cadre (18, 20, 22, 24) ou de son côté.

9. Procédé selon la revendication 8,
**caractérisé en ce**
**que** le cadre ou son côté (18, 20, 22, 24, 124, 224, 324) est extrudé dans une géométrie parallélépipédique avec une surface de base (34), des surfaces latérales (40, 42) partant de celle-ci et une surface supérieure (44) opposée à ladite surface de base, sachant que la surface de base est traversée par une fente longitudinale formant une ouverture (38) et se prolongeant dans le logement.

10. Procédé selon la revendication 8 ou 9,
**caractérisé en ce**
**que** le cadre (18, 20, 22, 24, 124, 224, 324) est extrudé sur les éléments en forme de plaque (26, 28) de telle sorte que ses bords (30, 32) traversent une des surfaces latérales (40, 42) ou la surface supérieure (44) du cadre, respectivement de son côté.

11. Procédé selon une des revendications 8 à 10,
**caractérisé en ce**
**que** le cadre (18, 20, 22, 24) ou son côté est doté d'une lèvre d'étanchéité (56) qui déborde aussi bien de la surface supérieure (44) que de la surface latérale (42) du cadre ou de son côté, opposée au module.

12. Procédé selon une des revendications 8 à 11,
**caractérisé en ce**
**que** l'extrusion est réalisée par une buse d'extrusion montée de manière fixe ou tournant le cas échéant autour de son axe, le long de laquelle le module se déplace guidé par un robot.

13. Dispositif de manipulation destiné à réaliser le procédé selon au moins la revendication 8 avec une buse d'extrusion déplaçable le long du bord s'étendant sur tout le pourtour du module.
